# EUROPEAN PATENT SPECIFICATION

(11) **EP 0 890 949 B1**
(45) Date of publication and mention of the grant of the patent: **23.11.2005**
(21) Application number: 97307387.7
(22) Date of filing: 22.09.1997
(51) Int. Cl.: G11B 20/10, G11B 19/12, G11B 20/12

(54) **Digital audio processing system compatible with digital versatile disk video standard**
Digitales mit dem Standard für digitale vielseitige Videoplatte (DVD) kompatibles Audioverarbeitungssystem
Système de traitement audio compatible avec la norme pour le disque numérique polyvalent (DVD)

(30) Priority: 11.07.1997 KR 9732373
(43) Date of publication of application: 13.01.1999
(73) Proprietor: SAMSUNG ELECTRONICS CO., LTD., Suwon City, Kyungki-do (KR)
(72) Inventor: Heo, Jung-Kwon, Songpa-gu, Seoul (KR); Heo, Jae-Hoon, Kwonsun-gu, Suwon-city, Kyungki-do (KR)
(74) Representative: Chugg, David John

(56) References cited:
- EP-A- 0 530 468
- EP-A- 0 758 125
- EP-A- 0 758 126
- EP-A- 0 777 227

## Description

The present invention relates to a digital audio processing system compatible with a digital versatile disk (DVD) video standard, and more particularly, to a digital audio processing system for providing digital audio data having a higher quality than the quality of digital audio data provided by DVD video standard while processing the digital audio data so that it can be reproduced even in a DVD reproducer adopting the DVD video standard.

A compact disk (CD) is widely used as a recording medium of audio data. However, such a CD which can contain digital audio data expressed as a sampling frequency of 44.1KHz and 16 quantization bits, does not provide an audio quality provided by an original recording master.

Through many a recent research, it has been known to need to sample an audio signal using a sampling frequency of 192KHz and 24 quantization bits, in order to provide the same audio quality as that provided by an original recording master. The high quality audio signal requires a high data transmission rate by a characteristic of the signal. An existing DVD can provide a physically high data transmission rate such as to provide the same audio quality as an original recording master. However, an existing DVD video standard allows audio data which is linearly pulse code modulated by a sampling frequency of 96KHz at maximum and 24 quantization bits to be recorded on a DVD disk.

Meanwhile, Japanese companies such as Sony Corporation and Sharp Company Limited have proposed a new audio format, called a direct stream digital audio system in order to provide a higher quality audio than the audio quality provided by the existing DVD video standard. The direct stream digital audio system disclosed via "AES the 100th Convention, Preprint 4163" by Ayataka Nishino, Gen Ichimura, Yoshizumi Inazawa, Norikazu Horikawa and Tadao Suzuki in Sony Corporation Shibaura Technology Center, Tokyo, Japan. According to this system, an analog audio signal is sigma-delta-analog-to-digital converted so as to be expressed as a sampling frequency of 64fs and a quantization bit of one bit. The bitstream data obtained by such a sigma-delta-digital-to-analog conversion is recorded on a recording medium by a direct stream digital (DSD) recorder and reproduced from the recording medium. The bitstream data reproduced from the recording medium by the DSD reproducer is sigma-delta-analog-to-digital converted as a sampling frequency of 64fs (fs is a sampling frequency of analog-to-digital conversion) and a quantization bit of one bit. The analog audio signal obtained by such an analog-to-digital conversion is filtered by an analog filter. The direct stream digital audio system uses the whole data rate of 2.8Mbps or so. The data rate can be accommodated in an existing DVD. Thus, if such a system is used to record an audio signal on a DVD, an audio quality higher than that provided by the existing DVD video standard can be provided.

However, when digital audio data of a higher audio quality than that provided by linear pulse-code-modulation (PCM) audio data of 96KHz and 24 bits, is recorded on an existing DVD, a DVD video reproducer which has been fabricated to process audio data according to the DVD video standard cannot reproduce the digital audio data recorded on the DVD.

Also, the direct stream digital audio system is not compatible with the existing DVD video standard. Thus, a reproducer which has been designed according to the DVD video standard cannot reproduce audio data which is processed according to the direct stream digital audio system and is recorded on the DVD.

With a view to solve or reduce the above problems it is an aim of preferred embodiments of the present invention to provide a digital audio processing system for providing digital audio data having a higher quality than the quality of digital audio data provided by DVD video standard while being compatible with an existing DVD video standard.

EP 0 758 126 discloses a recording medium and a recording/reproducing apparatus which realizes high sound quality and is playable on a conventional Compact Disk (CD) reproducing apparatus. The recording medium has a first layer and a second layer, wherein an audio program is recorded on the first layer in the conventional data format and on the second layer in a new data format. The new data format is a 64 fs/one-bit format. The claims appended hereto are characterised over the disclosure of this document.

EP 0 758 126 discloses a recording medium providing improved sound quality over that provided by a first generation CD by having a higher sampling rate and has a data format of 1-bit ΔΣ modulation.

According to the present invention there is provided an apparatus and method as set forth in the appended claims. Preferred features of the invention will be apparent from the dependent claims, and the description which follows.

According to a first aspect of the present invention, there is provided a digital audio recording processing apparatus for a digital versatile disk (DVD), the digital audio recording processing apparatus comprising: a decimation filtering means for decimation filtering digital audio data; a sampling and filtering means for sampling and filtering the digital audio data; a recorder for recording the digital audio data on an optical disk; characterised in that: the decimation filtering means is arranged for decimation-filtering first digital audio data and generating second digital audio data which meets the DVD video standard; the sampling and filtering means is arranged for up-sampling and filtering the second digital audio data wherein a decimation ratio of said decimation filtering means is the same as a reciprocal of a sampling rate for up-sampling in said sampling and filtering means, and outputting third digital audio data obtained by the up-sampling and filtering; the recorder is arranged for recording the second digital audio data and encoded residual data on a DVD; and the system further comprises: a subtraction means for subtracting third digital audio data from corresponding first digital audio data and generating residual data which can restore the first digital audio data; and an encoding means for encoding the residual data generated by the subtraction means and generating encoded residual data; wherein the first digital audio data provides a higher audio quality than that provided by the DVD video standard.

According to another aspect of the present invention, there is provided digital audio reproducing processing apparatus comprising: an optical disk for storing digital audio data; a reader for reading digital audio data from the optical disk; a decoding means for decoding the digital audio data; a reproducer for reproducing the digital audio data; characterised in that: the optical disk is a digital versatile disk (DVD) for storing first digital audio data which meets the DVD video standard and encoded residual data for providing digital audio data having a higher quality than the quality of digital audio data provided by the DVD video standard; the reader is arranged for reading the first digital audio data and the encoded residual data; and the reproducer is arranged for reproducing the first digital audio data; the decoding means is arranged for decoding the encoded residual data and generating the residual data; and the system further comprises: a sampling and filtering means for filtering and up-sampling, to the same sampling frequency of the residual data, the read first digital audio data and outputting the resultant second digital audio data; an addition means for adding the second digital audio data and the residual data to thereby generate third digital audio data having a higher audio quality than that provided by the DVD video standard; and a reproducer for reproducing the third digital audio data

For a better understanding of the invention, and to show how embodiments of the same may be carried into effect, reference will now be made, by way of example, to the accompanying diagrammatic drawings, in which:
Figure 1 is a block diagram showing a digital audio recording processing apparatus according to one embodiment of the present invention;
Figure 2 is a block diagram showing a digital audio reproduction processing apparatus corresponding to the Figure 1 apparatus;
Figure 3 is a block diagram showing a digital audio recording processing apparatus according to another embodiment of the present invention; and
Figure 4 is a block diagram showing a digital audio reproduction processing apparatus corresponding to the Figure 3 apparatus.

Preferred embodiments of the present invention will be described in detail with reference to the accompanying drawings.

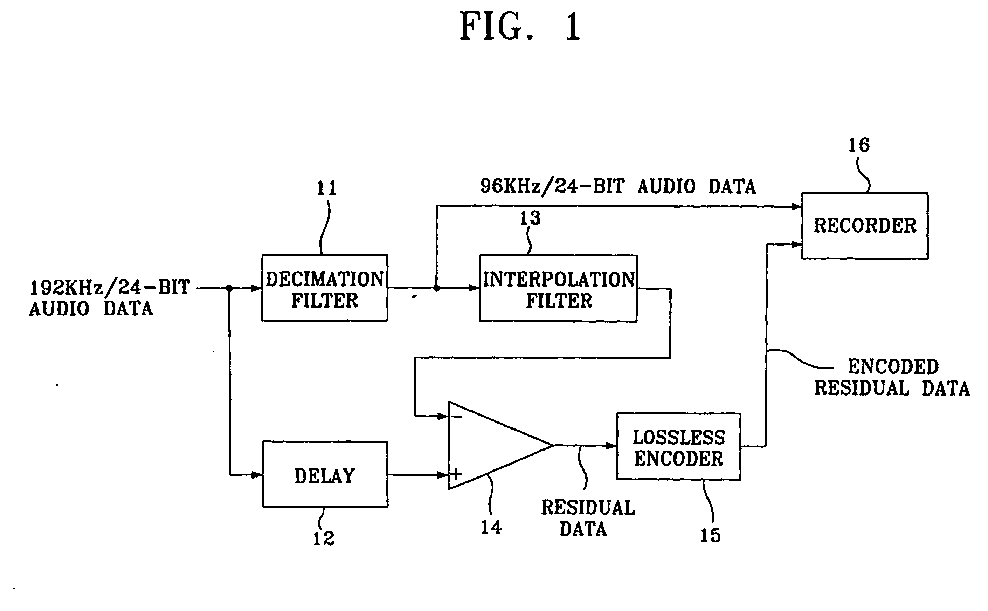

Referring to Figure 1 showing a digital audio recording processing apparatus according to one embodiment of the present invention, digital audio data is input to a decimation filter 11 and a delay 12. The decimation filter 11 performs decimation-filtering of the received digital audio data according to a predetermined decimation rate "M", in order to obtain the digital audio data allowed by the DVD video standard. In more detail, the decimation filter 11 low-pass-filters the received digital audio data and down-samples the low-pass-filtered audio data by the decimation rate "M". In the case that the digital audio data input to the Figure 1 apparatus is expressed as the sampling frequency of 192KHz and 24 quantization bits, the decimation filter 11 decimation-filters the received digital audio data by a decimation rate of 2:1. Therefore, the digital audio data appropriate for the DVD video standard, that is, the digital audio data which is expressed as the sampling frequency of 96KHz and 24 quantization bits is obtained from the decimation filter 11. The digital audio data obtained by the decimation filter 11 is input to an interpolating filter 13 and a recorder 16.

The interpolation filter 13 performs an interpolation-filtering of the received digital audio data at an interpolation ratio (L=1/M) which is a reciprocal to the decimation ratio. In more detail, the interpolation filter 13 up-samples the received digital audio data according to the interpolation ratio L and low-pass-filters the up-sampled audio data. The digital audio data obtained by the interpolation filter 13 is input to a subtracter 14.

Meanwhile, the delay 12 delays the received digital audio data by a predetermined interval of time. The predetermined interval of time is decided so that the subtracter 14 can perform a subtraction operation with respect to the same audio sample. The subtracter 14 subtracts the digital audio data received from the interpolation filter 13 from the digital audio data delayed in the delay 12. The residual data obtained by the subtraction result is input to a lossless encoder 15. The lossless encoder 15 encodes the residual data received from the subtracter 14 according to a well-known lossless encoding method, such as, a variable length coding method, an orthogonal transform coding method, and so on. By such a lossless encoding operation, the encoded residual data whose data amount is decreased compared with the residual data output from the subtracter 14 is obtained. The encoded residual data is input to the recorder 16.

The recorder 16 records the digital audio data received from the decimation filter 11 on a recording area of a DVD according to the DVD video standard and records the encoded residual data received from the lossless encoder 15 on another recording area of the DVD. The recording area of the DVD on which the encoded residual data is recorded is decided based on the existing DVD video standard. Since the encoded residual data has a small amount of data by a lossless encoding operation, it can be recorded on a recording area of a DVD which is not defined by the DVD video standard.

Therefore, a DVD video reproducer which is designed by the DVD video standard can reproduce the data recorded on the DVD by the Figure 1 apparatus.

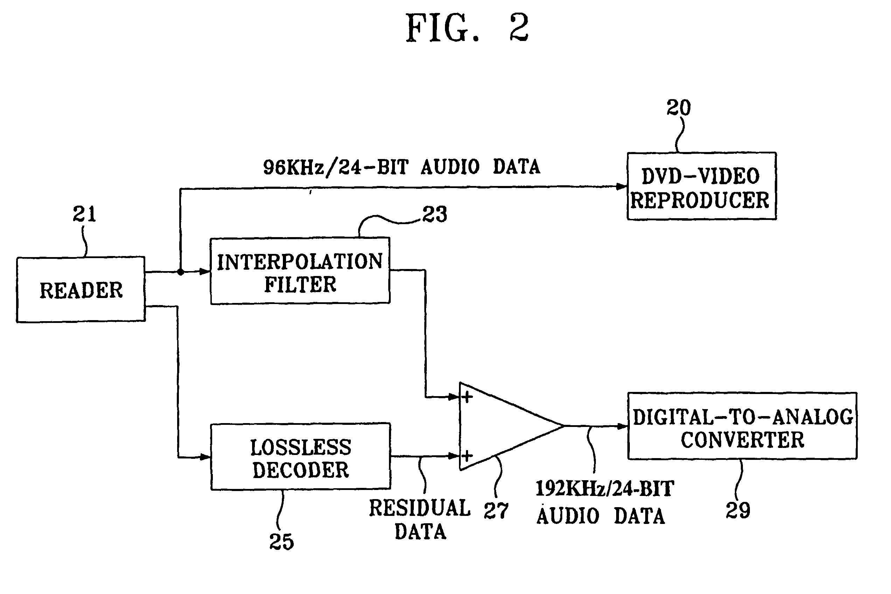

Figure 2 is a block diagram showing a digital audio reproduction processing apparatus corresponding to the Figure 1 apparatus. Referring to Figure 2, a reader 21 reads out the recorded data from the DVD on which the digital audio data has been recorded by the Figure 1 apparatus. The reader 21 outputs the digital audio data which is expressed as a sampling frequency of 96KHz and 24 quantization bits among the read data to a DVD video reproducer 20 and an interpolation filter 23, and outputs the encoded residual data among the read data to a lossless decoder 25. The DVD video reproducer 20 which is a general DVD video reproducer to be designed to fit the DVD video standard, reproduces the digital audio data to be received from the reader 21.

The interpolation filter 23 which performs the same operation as that of the above-described interpolation filter 13, interpolation-filters the received digital audio data, to thereby generate the digital audio data which is expressed as a sampling frequency of 192KHz and 24 quantization bits. The digital audio data is input to an adder 27. A lossless decoder 25 losslessly decodes the encoded residual data received from the reader 21 to generate the residual data. The residual data is same as that output from the subtracter 14 of Figure 1 since it has been losslessly encoded and decoded. The residual data is input to an adder 27.

The adder 27 adds the digital audio data received from the interpolation filter 23 and the residual data received from the lossless decoder 25, and generates the digital audio data which is expressed as the digital audio data which is expressed as a sampling frequency of 192KHz and 24 quantization bits. The digital audio data generated by the adder 27 is input to a digital-to-analog converter 29 constituting a dedicated reproducer according to the present invention for reproducing the audio data obtained by the adder 27, by which it is converted into an analog audio signal.

Since the analog audio signal is a signal obtained by digital-to-analog converting the digital audio data which is expressed as a sampling frequency of 192KHz and 24 quantization bits, an audio having a higher quality than that provided by the existing DVD video standard can be provided to users.

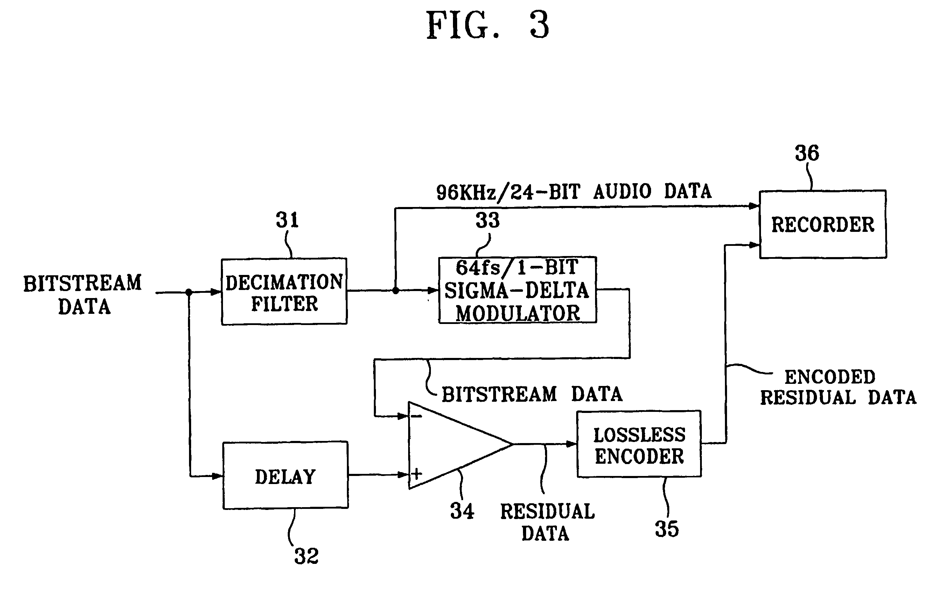

Figure 3 is a block diagram showing a digital audio recording processing apparatus according to another embodiment of the present invention. The Figure 3 apparatus receives bitstream data provided by a direct stream digital audio system differently from the above-described Figure 1 apparatus. The bitstream data which is expressed as a sampling frequency of 64fs and one quantization bit as described above, is input to a decimation filter 31 and a delay 32. The decimation filter 31 performs a decimation-filtering of the received bitstream data according to a predetermined decimation ratio, to thus generate digital audio data which is expressed as the digital audio data which is expressed as a sampling frequency of 96KHz and 24 quantization bits. In more detail, the decimation filter 31 low-pass-filters the received bitstream and then performs a decimation operation with respect to the low-pass-filtered data according to a decimation ratio determined on the basis of a sampling ratio of a 64fs/1-bit sigma-delta modulator 33. Thus, the audio data which meets the DVD video standard, that is, the digital audio data which is expressed as the digital audio data as a sampling frequency of 96KHZ and 24 quantization bits is obtained by the decimation filter 31. The digital audio data is input to a recorder 36 and a 64fs/i-bit sigma-delta modulator 33. The 64fs/1-bit sigma-delta modulator 33 sigma-delta modulates the digital audio data received from the decimation filter 31, and generates bitstream data which is expressed as a sampling frequency of 64fs and one quantization bit. The 64fs/1-bit bitstream data includes only a lowband component of a frequency band possessed by the bitstream data which has not been input to the decimation filter 31 yet, due to a decimation-filtering of the decimation filter 31, which is input to a subtracter 34.

Meanwhile, the delay 32 delays the received digital audio data by a predetermined interval of time. The predetermined interval of time is decided so that the subtracter 34 can perform a subtraction operation with respect to the same audio sample. The subtracter 34 subtracts the bitstream data received from the 64fs/1-bit sigma-delta modulator 33 from the bitstream data delayed in the delay 32. The residual data obtained by the subtraction result is input to a lossless encoder 35. The lossless encoder 35 encodes the residual data received from the subtracter 34 according to a lossless encoding method such as a variable length coding method and an orthogonal transform coding method. By such a lossless encoding operation, the encoded residual data whose data amount is decreased compared with the residual data output from the subtracter 34 is obtained. The encoded residual data is input to the recorder 36.

The recorder 36 records the digital audio data received from the decimation filter 31 on a recording area of a DVD according to the DVD video standard and records the encoded residual data received from the lossless encoder 35 on another recording area of the DVD. The recording area of the DVD on which the encoded residual data is recorded is decided based on the existing DVD video standard.

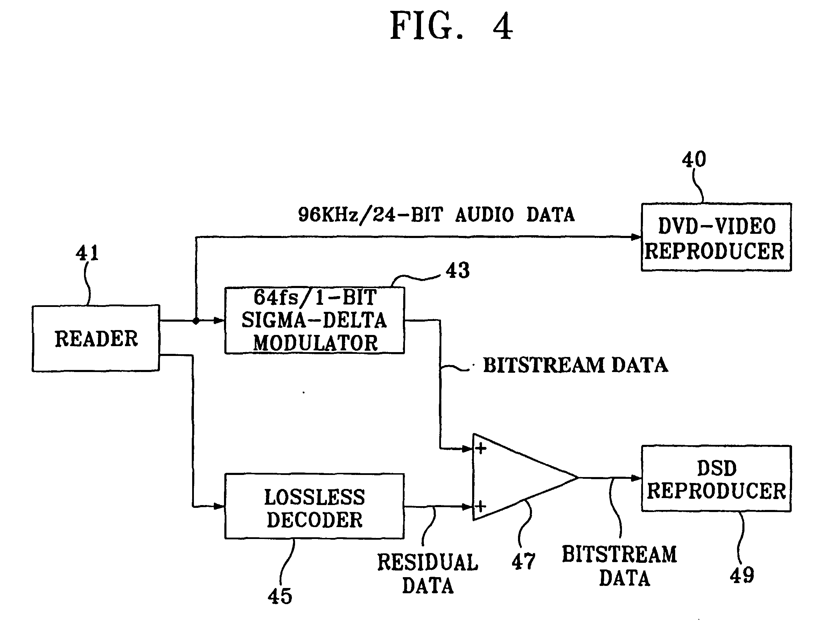

Referring to Figure 4 showing a digital audio reproduction processing apparatus corresponding to the Figure 3 apparatus, a reader 41 reads out the recorded data from the DVD on which the digital audio data has been recorded by the Figure 3 apparatus. The reader 41 outputs the digital audio data which is expressed as a sampling frequency of 96KHz and 24 quantization bits among the read data to a general DVD video reproducer 40 which can reproduce the digital audio data. The reader 41 also outputs the digital audio data to the 64fs/1-bit sigma-delta modulator 43, and outputs the encoded residual data among the read data to a lossless decoder 45.

The 64fs/1-bit sigma-delta modulator 43 which performs the same operation as that of the above-described 64fs/1-bit sigma-delta modulator 43, sigma-delta modulates the received digital audio data, to thereby generate the bitstream data which is expressed as a sampling frequency of 64fs and a one-bit quantization bit. The bitstream data is input to an adder 47.

Meanwhile, the lossless decoder 45 losslessly decodes the encoded residual data received from the reader 41 to generate the residual data. The residual data is the same as that output from the subtracter 34 of Figure 3. The residual data is input to an adder 47. The adder 47 adds the bitstream data received from the 64fs/1-bit sigma-delta modulator 43 and the residual data received from the lossless decoder 45, and generates the bitstream data which is the same as that proposed by a direct stream digital audio system. The bitstream data is reproduced by a DSD reproducer 49 for reproducing the bitstream data proposed by the direct stream digital audio system.

The above-described embodiments have been described with respect to the analog audio data which is expressed as a sampling frequency of 192KHz and 24 quantization bits and the bitstream data proposed by the direct stream digital audio system. However, the digital audio processing system according to the present invention can use digital audio data of another sampling frequency which can provide an audio having a higher quality than that provided by the existing DVD video standard. Such digital audio data has a sampling frequency higher than 96KHz.

As described above, the digital audio processing system according to embodiments of the present invention can provide an audio having a higher quality than that provided by the existing DVD video standard and can process the digital audio data so that it can be reproduced in a DVD video reproducer designed by the DVD video standard. Also, the digital audio processing system can process the bitstream data proposed by the direct stream digital audio system so that it can be reproduced in a DSD reproducer which is designed to adapt itself to a direct stream digital audio system as well as a DVD video reproducer which is designed according to the DVD video standard.

Although preferred embodiments of the invention have been specifically described herein, numerous modifications may be made thereto without departing from the scope of the invention.

## Claims

1. A digital audio recording processing apparatus for a digital versatile disk (DVD), the digital audio recording processing apparatus comprising:
a decimation filtering means (11) for decimation filtering digital audio data;
a sampling and filtering means (13) for sampling and filtering the digital audio data;
a recorder (16) for recording the digital audio data on an optical disk;
**characterised in that**:
the decimation filtering means (11) is arranged for decimation-filtering first digital audio data and generating second digital audio data which meets the DVD video standard;
the sampling and filtering means (13) is arranged for up-sampling and filtering the second digital audio data wherein a decimation ratio of said decimation filtering means (11) is the same as a reciprocal of a sampling rate for up-sampling in said sampling and filtering means (13), and outputting third digital audio data obtained by the up-sampling and filtering;
the recorder (16) is arranged for recording the second digital audio data and encoded residual data on a DVD;
and the system further comprises:
a subtraction means (12, 14) for subtracting third digital audio data from corresponding first digital audio data and generating residual data which can restore the first digital audio data; and
an encoding means (15) for encoding the residual data generated by the subtraction means and generating encoded residual data;
wherein the first digital audio data provides a higher audio quality than that provided by the DVD video standard.

2. The digital audio recording processing apparatus according to claim 1, wherein said subtraction means (12, 14) comprises:
a delay (12) for delaying the first digital audio data; and
a subtracter (14) for subtracting third digital audio data received from said sampling and filtering means (13) from the corresponding first digital audio data received from said delay (12).

3. The digital audio recording processing apparatus according to claim 1, or 2, wherein said encoding means (15) is a lossless encoder.

4. The digital audio recording processing apparatus according to any of the preceding claims, wherein said recorder (16) records the second digital audio data and the encoded residual data on a DVD with a format which allows the recorded result to be reproduced from a DVD video reproducer which is designed according to the DVD video standard.

5. The digital audio recording processing apparatus according to any of the preceding claims, wherein when the first digital audio data has a frequency of N times a sampling frequency possessed by the digital audio data which meets the DVD video standard in which N is an integer, said decimation filtering means (11) decimation-filters the first digital audio data at an N:1 ratio to generate the second digital audio data and said sampling and filtering means (13) up-samples the first digital audio data at a 1:N ratio to generate the third digital audio data.

6. The digital audio recording processing apparatus according to claim 5, wherein when the first digital audio data is audio data which has been sampled with a 192KHz sampling frequency and quantized with 24 bits, said decimation filtering means (11) decimation-filters the input digital audio data at a 2:1 ratio and said sampling and filtering means (13) interpolation-filters the digital audio data at a 1:2 ratio.

7. The digital audio recording processing apparatus according to claim 1, wherein when the first digital audio data is bitstream data which is obtained by a sigma-delta analog-to-digital conversion and is expressed as a 64fs sampling frequency and one bit, said sampling and filtering means (13) sigma-delta-modulates the second digital audio data to generate bitstream data which is expressed as 64fs and one bit.

8. A digital audio reproducing processing apparatus comprising:
an optical disk for storing digital audio data;
a reader (21) for reading digital audio data from the optical disk;
a decoding means (25, 45) for decoding the digital audio data;
a reproducer (20) for reproducing the digital audio data;
**characterised in that**:
the optical disk is a digital versatile disk (DVD) for storing first digital audio data which meets the DVD video standard and encoded residual data for providing digital audio data having a higher quality than the quality of digital audio data provided by the DVD video standard;
the reader (21) is arranged for reading the first digital audio data and the encoded residual data;
the reproducer (20) is arranged for reproducing the first digital audio data;
the decoding means (25, 45) is arranged for decoding the encoded residual data and generating the residual data; and
the system further comprises:
a sampling and filtering means (23, 43) for filtering and up-sampling, to the same sampling frequency of the residual data, the read first digital audio data and outputting the resultant second digital audio data;
an addition means (27, 47) for adding the second digital audio data and the residual data to thereby generate third digital audio data having a higher audio quality than that provided by the DVD video standard; and
a reproducer (29, 49) for reproducing the third digital audio data.

9. The digital audio reproducing processing apparatus according to claim 8, wherein said reproducer (20) is a DVD video reproducer for reproducing digital audio data which meets the DVD video standard.

10. The digital audio reproducing processing apparatus according to claim 8 or 9, wherein when the third digital audio data has a frequency of N times a sampling frequency possessed by the first digital audio data in which N is an integer, said sampling and filtering means (23, 43) up-samples the second digital audio data at a 1:N ratio.

11. The digital audio reproducing processing apparatus according to claim 10, wherein the third digital audio data is audio data which has been sampled with a 192KHz sampling frequency and quantized with 24 bits.

12. The digital audio reproducing reprocessing apparatus according to claim 8 or 9, further comprising a reproducer for reproducing the bitstream data when the third digital audio data is bitstream data which is obtained by a sigma-delta analog-to-digital conversion and is expressed as a 64fs sampling frequency and one bit, wherein said sampling and filtering means sigma-delta-modulates the second digital audio data to generate bitstream data which is expressed as 64fs and one bit and supply the result to the reproducer.

## Patentansprüche

1. Digitale Audio-Aufzeichnungs-Verarbeitungsvorrichtung für eine DVD (Digital Versatile Disk), wobei die digitale Audio-Aufzeichnungs-Verarbeitungsvorrichtung aufweist:
eine Dezimations-Filtereinrichtung (11) für eine Dezimations-Filterung von digitalen Audio-Daten;
eine Abtast- und Filtereinrichtung (13) zum Abtasten und Filtern der digitalen Audio-Daten;
eine Aufzeichnungseinrichtung (16) zum Aufzeichnen der digitalen Audio-Daten auf einer optischen Disk;
**dadurch gekennzeichnet, dass**
die Dezimations-Filtereinrichtung (11) für eine Dezimations-Filterung erster digitaler Audio-Daten und zum Erzeugen zweiter digitaler Audio-Daten, die den DVD-Video-Standard erfüllen, aufgebaut ist;
die Abtast- und Filtereinrichtung (13) für ein Upsampling und Filtern der zweiten digitalen Audio-Daten, wobei ein Dezimationsverhältnis der Dezimations-Filtereinrichtung (11) dasselbe wie das Reziproke einer Abtastrate für ein Upsampling in der Abtast- und Filtereinrichtung (13) ist, und zum Ausgeben der dritten digitalen Audio-Daten, erhalten durch das Upsampling und die Filterung, aufgebaut ist;
die Aufzeichnungseinrichtung (16) zum Aufzeichnen der zweiten digitalen Audio-Daten und der codierten Rest-Daten auf einer DVD aufgebaut ist;
und das System weiterhin aufweist:
eine Subtrahiereinrichtung (12, 14) zum Subtrahieren dritter digitaler Audio-Daten von entsprechenden ersten digitalen Audio-Daten und zum Erzeugen von Rest-Daten, die die ersten digitalen Audio-Daten wiederherstellen können; und
eine Codiereinrichtung (15) zum Codieren der Rest-Daten, erzeugt durch die Subtrahiereinrichtung, und zum Erzeugen von codierten Rest-Daten;
wobei die ersten digitalen Audio-Daten eine höhere Audio-Qualität als diejenige liefern, die durch den DVD-Video-Standard geliefert wird.

2. Digitale Audio-Aufzeichnungs-Verarbeitungsvorrichtung nach Anspruch 1, wobei die Subtrahiereinrichtung (12, 14) aufweist:
eine Verzögerung (12) zum Verzögern der ersten digitalen Audio-Daten; und
einen Subtrahierer (14) zum Subtrahieren dritter digitaler Audio-Daten, empfangen von der Abtast- und Filtereinrichtung (13), von den entsprechenden ersten digitalen Audio-Daten, empfangen von der Verzögerung (12).

3. Digitale Audio-Aufzeichnungs-Verarbeitungsvorrichtung nach Anspruch 1 oder 2, wobei die Codiereinrichtung (15) ein verlustfreier Codierer ist.

4. Digitale Audio-Aufzeichnungs-Verarbeitungsvorrichtung nach irgendeinem der vorhergehenden Ansprüche, wobei die Aufzeichnungseinrichtung (16) die zweiten digitalen Audio-Daten und die codierten Rest-Daten auf einer DVD mit einem Format aufzeichnet, das ermöglicht, dass das aufgezeichnete Ergebnis von einer DVD-Video-Wedergabeeinrichtung wiedergegeben werden kann, die entsprechend dem DVD-Video-Standard ausgelegt ist.

5. Digitale Audio-Aufzeichnungs-Verarbeitungsvorrichtung nach einem der vorhergehenden Ansprüche, wobei dann, wenn die ersten digitalen Audio-Daten eine Frequenz von N-mal einer Abtastfrequenz, die die digitalen Audio-Daten besitzen, die den DVD-Video-Standard erfüllt, wobei N eine ganze Zahl ist, haben, die Dezimations-Filtereinrichtung (11) die ersten digitalen Audio-Daten bei einem Verhältnis von N:1 einer Dezimations-Filterung unterwirft, um die zweiten digitalen Audio-Daten zu erzeugen, und die Abtast- und Filtereinrichtung (13) die ersten digitalen Audio-Daten bei einem Verhältnis von 1:N einem Upsampling unterwirft, um die dritten digitalen Audio-Daten zu erzeugen.

6. Digitale Audio-Aufzeichnungs-Verarbeitungsvorrichtung nach Anspruch 5, wobei dann, wenn die ersten digitalen Audio-Daten solche Audio-Daten sind, die mit einer Abtastfrequenz von 192kHz abgetastet worden sind und mit 24 Bits quantisiert worden sind, die Dezimations-Filtereinrichtung (11) die digitalen Eingangs-Audio-Daten bei einem Verhältnis von 2:1 einer Dezimations-Filterung unterwirft und die Abtast- und Filtereinrichtung (13) die digitalen Audio-Daten bei einem Verhältnis von 1:2 einer Interpolations-Filterung unterwirft.

7. Digitale Audio-Aufzeichnungs-Verarbeitungsvorrichtung nach Anspruch 1, wobei dann, wenn die ersten digitalen Audio-Daten Bitfolge-Daten sind, die durch eine Sigma-Delta-Analog/Digital-Umwandlung erhalten sind und als eine 64fs Abtastfrequenz und ein Bit ausgedrückt sind, die Abtast- und Filtereinrichtung (13) die zweiten digitalen Audio-Daten einem Sigma-Delta-Modulieren unterwirft, um Bitfolge-Daten zu erzeugen, die als 64fs und ein Bit ausgedrückt sind.

8. Digitale Audio-Aufzeichnungs-Verarbeitungsvorrichtung, die aufweist:
eine optische Platte zum Speichern von digitalen Audio-Daten;
eine Leseeinrichtung (21) zum Lesen digitaler Audio-Daten von der optischen Platte;
eine Decodiereinrichtung (25, 45) zum Decodieren der digitalen Audio-Daten;
eine Wiedergabeeinrichtung (20) zum Wiedergeben der digitalen Audio-Daten;
**dadurch gekennzeichnet, dass**
die optische Platte eine DVD (Digital Versatile Disk) zum Speichern erster digitaler Audio-Daten, die den DVD-Video-Standard erfüllen, und codierter Rest-Daten zum Bereitstellen von digitalen Audio-Daten, die eine höhere Qualität als die Qualität von digitalen Audio-Daten, bereitgestellt durch den DVD-Video-Standard haben, erfüllen;
die Leseeinrichtung (21) zum Lesen der ersten digitalen Audio-Daten und der codierten Rest-Daten aufgebaut ist;
die Wiedergabeeinrichtung (20) zum Wiedergeben der ersten digitalen Audio-Daten aufgebaut ist;
die Decodiereinrichtung (25, 45) zum Decodieren der codierten Rest-Daten und zum Erzeugen der Rest-Daten aufgebaut ist; und
das System weiterhin aufweist:
eine Abtast- und Filtereinrichtung (23, 43) zum Filtern und ein Upsampling, zu derselben Abtastfrequenz wie die Rest-Daten, der gelesenen, ersten digitalen Audio-Daten und zum Ausgeben der sich ergebenden, zweiten digitalen Audio-Daten;
eine Additionseinrichtung (27, 47) zum Addieren der zweiten digitalen Audio-Daten und der Rest-Daten, um **dadurch** dritte digitale Audio-Daten zu erzeugen, die eine höhere Audio-Qualität als diejenige haben, die durch den DVD-Video-Standard bereitgestellt ist; und
eine Wiedergabeeinrichtung (29, 49) zum Wiedergeben der dritten digitalen Audio-Daten.

9. Digitale Audio-Aufzeichnungs-Verarbeitungsvorrichtung nach Anspruch 8, wobei die Wiedergabeeinrichtung (20) eine DVD-Video-Wiedergabeeinrichtung zum Wiedergeben von digitalen Audio-Daten, die den DVD-Video-Standard erfüllen, ist.

10. Digitale Audio-Aufzeichnungs-Verarbeitungsvorrichtung nach Anspruch 8 oder 9, wobei dann, wenn die dritten digitalen Audio-Daten eine Frequenz von N-mal einer Abtastfrequenz besitzen, wobei diese Frequenz auch die ersten digitalen Audio-Daten haben, wobei N eine ganze Zahl ist, die Abtast- und Filtereinrichtung (23, 43) die zweiten digitalen Audio-Daten bei einem Verhältnis von 1:N einem Upsampling unterwirft.

11. Digitale Audio-Aufzeichnungs-Verarbeitungsvorrichtung nach Anspruch 10, wobei die dritten digitalen Audio-Daten solche Audio-Daten sind, die mit einer Abtastfrequenz von 192kHz abgetastet und mit 24 Bits quantisiert worden sind.

12. Digitale Audio-Aufzeichnungs-Verarbeitungsvorrichtung nach Anspruch 8 oder 9, die weiterhin eine Wiedergabeeinrichtung zum Wiedergeben der Bitdatenfolge-Daten, wenn die dritten digitalen Audio-Daten Bitdatenfolge-Daten sind, die durch eine Sigma-Delta-Analog/Digital-Umwandlung erhalten sind und als eine 64fs Abtastfrequenz und ein Bit ausgedrückt sind, aufweist, wobei die Abtast- und Filtereinrichtung die zweiten digitalen Audio-Daten einem Sigma-Delta-Modulieren unterwirft, um Bitdatenfolge-Daten zu erzeugen, die als 64fs und ein Bit ausgedrückt sind, und um das Ergebnis zu der Wiedergabeeinrichtung zuzuführen.

## Revendications

1. Dispositif de traitement d'enregistrement audio numérique pour un disque numérique polyvalent (DVD), le dispositif de traitement d'enregistrement audio numérique comprenant:
des moyens (11) de filtrage par décimation pour réaliser le filtrage par décimation des données audio numériques;
des moyens d'échantillonnage et de filtrage (13) pour réaliser l'échantillonnage et le filtrage des données audio numériques;
un enregistreur (16) pour enregistrer les données audio numériques sur un disque optique;
**caractérisé en ce que**:
les moyens de filtrage de décimation (11) sont agencés pour réaliser le filtrage par décimation des premières données audio numériques et générer des secondes données audio numériques qui satisfont au standard vidéo DVD;
les moyens d'échantillonnage et de filtrage (13) sont agencés pour réaliser un suréchantillonnage et filtrer les secondes données audio numériques, dans lequel un rapport de décimation desdits moyens de filtrage de décimation (11) sont identiques à l'inverse d'une cadence d'échantillonnage pour le suréchantillonnage dans lesdits moyens d'échantillonnage et de filtrage (13), et la délivrance de troisièmes données audio numériques obtenues au moyen du suréchantillonnage et du filtrage;
l'enregistreur (16) est agencé pour enregistrer les secondes données audio numériques et les données résiduelles codées sur un disque DVD; et
le système comprend en outre:
des moyens de soustraction (12, 14) pour soustraire des troisièmes données audio numériques à partir de premières données audio numériques correspondantes et générer des données résiduelles, qui peuvent restaurer les premières données audio numériques; et
des moyens de codage (15) pour coder les données résiduelles générées par les moyens de soustraction et pour générer les données résiduelles codées;
dans lequel les premières données audio numériques fournissent une qualité audio supérieure à ce qui est fourni par la norme vidéo DVD.

2. Dispositif de traitement d'enregistrement audio numérique selon la revendication 1, dans lequel lesdits moyens de soustraction (12, 14) comprennent:
un retard (12) pour retarder les premières données audio numériques; et
un soustracteur (14) pour soustraire les troisièmes données audio numériques reçues à partir desdits moyens d'échantillonnage et de filtrage (13) à partir des premières données audio numériques correspondantes reçues à partir dudit retard (12).

3. Dispositif de traitement d'enregistrement audio numérique selon la revendication 1 ou 2, dans lequel lesdits moyens de codage (15) sont un codeur sans perte.

4. Dispositif de traitement d'enregistrement audio numérique selon l'une quelconque des revendications précédentes, dans lequel ledit enregistreur (16) enregistre les secondes données audio numériques et les données résiduelles codées sur un DVD avec un format qui permet la reproduction du résultat enregistré à partir d'un dispositif de reproduction vidéo DVD, qui est conçu conformément à la norme vidéo DVD.

5. Dispositif de traitement d'enregistrement audio numérique selon l'une quelconque des revendications précédentes, dans lequel lorsque les premières données audio numériques possèdent une fréquence égale N fois une fréquence d'échantillonnage que possèdent les données audio numériques, fréquence qui satisfait la norme vidéo DVD, N étant un entier, lesdits moyens de filtrage à décimation (11) réalisent un filtrage à décimation des premières données audio numériques pour un rapport N:1 pour générer les secondes données audio numériques et lesdits moyens de filtrage et d'échantillonnage (13) réalisent un suréchantillonnage des premières données audio numériques dans un rapport 1:N pour générer les troisièmes données audio numériques.

6. Dispositif de traitement d'enregistrement audio numérique selon la revendication 5, dans lequel lorsque les premières données audio numériques sont des données audio qui ont été échantillonnées avec une fréquence d'échantillonnage de 192 kHz et sont quantifiées avec 24 bits, lesdits moyens de filtrage par décimation (11) réalisent un filtrage par décimation des données audio numériques d'entrée dans un rapport 2:1 et lesdits moyens d'échantillonnage et de filtrage (13) filtrent par interpolation les données audio numériques dans un rapport 1:2.

7. Dispositif de traitement d'enregistrement audio numérique selon la revendication 1, dans lequel, lorsque les premières données audio numériques sont des données de flux binaire, qui sont obtenues au moyen d'une conversion analogique / numérique sigma-delta et est exprimée sous la forme d'une fréquence d'échantillonnage de 64 fs et d'un bit, lesdits moyens d'échantillonnage et de filtrage (13) réalisent une modulation sigma-delta des secondes données audio numériques pour générer des données de flux binaire, qui sont exprimées sous la forme de 64 fs et d'un bit.

8. Dispositif de traitement de reproduction audio numérique comprenant:
un disque optique pour mémoriser des données audio numériques;
un lecteur (21) pour lire des données audio numériques à partir du disque optique;
des moyens de décodage (25, 45) pour décoder les données audio numériques;
un dispositif de reproduction (20) pour reproduire les données audio numériques;
**caractérisé en ce que**:
le disque optique est un disque numérique polyvalent (DVD) servant à mémoriser des premières données audio numériques qui satisfont à la norme vidéo DVD et des données résiduelles codées pour délivrer des données audio numériques ayant une qualité supérieure à la qualité des données audio numériques fournie par la norme vidéo DVD;
le lecteur (21) est agencé pour lire les premières données audio numériques et les données résiduelles codées;
le dispositif de reproduction (20) est agencé de manière à reproduire les premières données audio numériques;
les moyens de décodage (25, 45) sont agencés pour décoder les données résiduelles codées et générer les données résiduelles; et
le système comporte en outre:
des moyens d'échantillonnage et de filtrage (23, 43) pour réaliser le filtrage et le suréchantillonnage, à la même fréquence d'échantillonnage des données résiduelles, des premières données audio numériques lues et délivrer les secondes données audio numériques résultantes;
des moyens d'addition (27, 47) pour additionner les secondes données audio numériques et les données résiduelles de manière à générer de ce fait des troisièmes données audio numériques ayant une qualité audio supérieure à celle fournie par la norme vidéo DVD; et
un dispositif de reproduction (29, 49) pour reproduire les troisièmes données audio numériques.

9. Dispositif de traitement de reproduction audio numérique selon la revendication 8, dans lequel ledit dispositif de reproduction (20) est un dispositif de reproduction vidéo DVD pour reproduire des données audio numériques qui satisfont à la norme vidéo DVD.

10. Dispositif de traitement de reproduction audio numérique selon la revendication 8 ou 9, dans lequel lorsque les troisièmes données audio numériques possèdent une fréquence égale à N fois la fréquence d'échantillonnage que comporte les premières données audio numériques, N étant un entier, lesdits moyens d'échantillonnage et de filtrage (23, 43) réalisent un suréchantillonnage des secondes données audio numériques dans un rapport 1:N.

11. Dispositif de traitement de reproduction audio numérique selon la revendication 10, dans lequel les troisièmes données audio numériques sont des données audio qui ont été échantillonnées avec une fréquence d'échantillonnage de 192 kHz et ont été quantifiées avec 24 bits.

12. Dispositif de traitement de reproduction audio numérique selon la revendication 8 ou 9, comprenant en outre un dispositif de reproduction pour reproduire les données de flux binaire lorsque les troisièmes données audio numériques sont des données d'un flux binaire, qui est obtenu au moyen d'une conversion analogique / numérique sigma-delta et est exprimé sous la forme d'une fréquence d'échantillonnage de 64 fs et d'un bit, lesdits moyens d'échantillonnage et de filtrage réalisant une démodulation sigma-delta des secondes données audio numériques pour générer des données de flux binaire, qui sont exprimées par 64 fs et un bit, et envoient le résultat au dispositif de reproduction.
